# EUROPEAN PATENT SPECIFICATION

(11) **EP 2 390 560 B1**
(45) Date of publication and mention of the grant of the patent: **28.01.2015**
(21) Application number: 10733427.8
(22) Date of filing: 14.01.2010
(51) Int. Cl.: F21S 8/10, F21W 101/10, F21W 101/14, F21Y 101/00

(54) **AIR-PERMEABLE MEMBER AND PROCESS FOR PRODUCING SAME**
LUFTDURCHLÄSSIGES ELEMENT UND HERSTELLUNGSVERFAHREN DAFÜR
ÉLÉMENT PERMÉABLE À L'AIR ET PROCÉDÉ POUR SA PRODUCTION

(30) Priority: 21.01.2009 JP 2009010963
(43) Date of publication of application: 30.11.2011
(73) Proprietor: Nitto Denko Corporation, Ibaraki-shi Osaka 567-8680 (JP)
(72) Inventor: OMURA Kazuhiro, Ibaraki-shi Osaka 567-8680 (JP)
(74) Representative: Intès, Didier Gérard André
(86) International application number: PCT/JP2010/050340
(87) International publication number: WO 2010/084820

(56) References cited:
- EP-A1- 1 835 227
- EP-A1- 1 892 029
- EP-A1- 1 955 901
- EP-A1- 1 970 258
- EP-A2- 1 363 484
- WO-A1-98/31966
- JP-A- 2001 212 845
- JP-A- 2001 212 845
- JP-A- 2003 258 444
- JP-A- 2006 190 656
- JP-A- 2006 324 260
- JP-A- 2007 201 110

## Description

### TECHNICAL FIELD

The present invention relates to a ventilation member to be attached to a casing of an electrical component, etc. and a method for producing the ventilation member.

### BACKGROUND ART

A ventilation member is attached to a housing that accommodates electrical components, such as an automobile lamp, motor, sensor, switch, and ECU (electronic control unit), in order to ensure ventilation between the interior and the exterior of the housing so as to relax a change in pressure inside the housing caused by a change in temperature and prevent the entry of foreign matters into the interior of the housing.

As such a ventilation member, a ventilation member obtained by attaching a porous polytetrafluoroethylene membrane to a support body made of an elastomer has been used conventionally. For example, Patent Literature 1 discloses a ventilation member including a support body made of Milastomer produced by Mitsui Chemicals, Inc. (registered trademark, an elastomer having a sea-island structure formed of polypropylene crystals and crosslinked ethylene-propylene terpolymer).

Another example of ventilation member is disclosed in EP 1 970 258.

### CITATION LIST

### Patent Literature

PTL 1: JP 2001-143524 A

### SUMMARY OF INVENTION

### Technical Problem

In recent years, space-saving of automobiles has been achieved and electrical components, such as a small-sized motor, are mounted outside the bodies of the automobiles. In this situation, ventilation members have been required to be usable under various environmental conditions. More specifically, the ventilation members have been required to have high chemical resistance, weatherability, and ozone resistance.

In view of the foregoing, the present invention is intended to provide a ventilation member with high chemical resistance, weatherability, and ozone resistance.

### Solution to Problem

The present invention that has achieved the above-mentioned object provides a ventilation member according to appended claim 1. It includes:
a support body with a through hole, composed of vulcanized ethylene-propylene-diene rubber;
an adhesive layer provided around the through hole; and
a gas permeable membrane provided on the support body via the adhesive layer so as to cover the through hole.

The adhesive layer contains rubber. Preferably, the rubber is ethylene-propylene-diene rubber. The gas permeable membrane is a porous fluororesin membrane. Moreover, the gas permeable membrane preferably has been subject to an oil repellent treatment.

The present invention also provides a method for producing a ventilation member according to appended claim 5. It includes:
a step of applying an adhesive around a through hole of a support body composed of vulcanized ethylene-propylene-diene rubber; and
a step of bonding a gas permeable membrane to the support body via the adhesive.

In this production method, the adhesive is a rubber cement. Preferably, the rubber cement contains unvulcanized ethylene-propylene-diene rubber.

### Advantageous Effects of Invention

According to the present invention, there is provided a ventilation member with high chemical resistance, weatherability, and ozone resistance.

### BRIEF DESCRIPTION OF THE DRAWINGS

Fig. 1 is a cross-sectional view showing an example of the ventilation member of the present invention.
Fig. 2 is a schematic view illustrating an example of the method for producing the ventilation member of the present invention.

### DESCRIPTION OF EMBODIMENTS

As a support body of the ventilation member of the present invention, a support body having a through hole and composed of vulcanized ethylene-propylene-diene rubber (EPDM rubber) is used. The through hole of the support body serves to ensure gas permeability when the ventilation member is used for a housing. The vulcanized EPDM rubber is a material with high chemical resistance, weatherability, and ozone resistance as well as excellent heat resistance and mechanical strength.

As a gas permeable membrane used for the ventilation member of the present invention, a gas permeable membrane commonly used for ventilation members can be used. Particularly, a porous fluororesin membrane is preferable from the viewpoint of chemical resistance and heat resistance. The porous fluororesin membrane is composed of a fluororesin such as polyvinylidene fluoride, polytetrafluoroethylene (PTFE), an ethylene-tetrafluoroethylene copolymer, a tetrafluoroethylene-hexafluoropropylene copolymer, and a tetrafluoroethylene-perfluoroalkyl vinyl ether copolymer. Among these, PTFE is most preferable from the viewpoint of versatility.

Preferably, the gas permeable membrane has been subject to an oil repellent treatment. The oil repellent treatment can enhance further the chemical resistance of the gas permeable membrane and prevent the adhesion of oil-containing dust, etc. to the gas permeable membrane.

In the ventilation member of the present invention, the gas permeable membrane is provided on the support body via the adhesive layer so as to cover the through hole of the support body. In this regard, EPDM rubber is a material with poor adhesion. A porous fluororesin membrane, such as a porous PTFE membrane, that is commonly used as a gas permeable membrane also is a material with poor adhesion. This raises a problem of how to integrate the EPDM rubber with the gas permeable membrane. Hence, the present inventor studied on this and found the following. When a so-called rubber cement, which is obtained by dissolving unvulcanized rubber in a solvent, is used as an adhesive composing the adhesive layer, molecules of the rubber enter into the support body at molecular level and are vulcanized with sulfur remaining in the support body. Thereby, the adhesive layer is bound chemically to the support body. In the meantime, the rubber cement enters into pores of the porous fluororesin membrane and an anchor effect is exerted so as to generate a bonding strength between the adhesive layer and the porous fluororesin membrane. As a result, satisfactory adhesion between the support body and the gas permeable membrane can be ensured. Based on the above-mentioned findings, it is preferable that the support body and the gas permeable membrane are bonded to each other with the rubber cement. Accordingly, it is preferable that the adhesive layer contains rubber. The type of the rubber is not particularly limited, and both of natural rubber and synthetic rubber can be used. EPDM rubber is preferable from the viewpoint of adhesive strength, chemical resistance, weatherability; and ozone resistance of a bonding portion.

The size of the support body may be decided according to sizes used for support bodies of common ventilation members. The thickness of the gas permeable membrane may be decided according to thicknesses used for common gas permeable membranes. Various properties of the gas permeable membrane may be equivalent to or better than those of the common gas permeable membranes.

Such a configuration allows the ventilation member to have high chemical resistance, weatherability and ozone resistance as well as excellent heat resistance and mechanical strength.

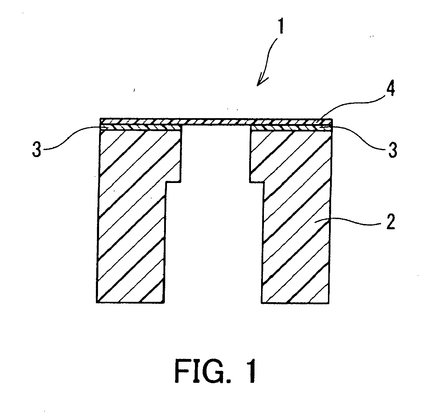

Fig. 1 shows a cross-sectional view of a structural example of the ventilation member. A support body 2 is cylindrical and has a through hole at a center thereof. The material of the support body 2 is vulcanized EPDM rubber. An adhesive layer 3 is provided around the through hole, on an upper face of the support body 2. Most preferably, the adhesive layer 3 is made of a rubber cement obtained by dissolving EPDM rubber in a solvent. A gas permeable membrane 4 is provided on the adhesive layer 3 so as to cover the through hole. The through hole and the gas permeable membrane 4 make it possible to ensure the ventilation between the interior and the exterior of the housing and relax a change in pressure inside the housing caused by a change in temperature. Furthermore, the gas permeable membrane 4 prevents the entry of foreign matters into the interior of the housing. A ventilation member 1 thus configured is used being fitted in a through hole provided in the housing. This through hole has a diameter equal to or less than a diameter of the cylindrical support body.

The ventilation member may be provided with a cover member for protecting the gas permeable membrane, according to a known method.

Next, the method for producing the ventilation member will be described. Conventionally, a ventilation member has been produced by, for example, fusion-bonding a gas permeable membrane to a support body. However, the vulcanization EPDM rubber is a material difficult to be fusion-bonded. Moreover, it is a material having poor adhesion as mentioned above. Thus, it also is conceivable to mold the support body and the gas permeable membrane integrally. However, the integral molding deteriorates the gas permeability of the gas permeable membrane as in the after-mentioned comparative example. As a result of intensive studies, the present inventor has found that when the rubber cement obtained by dissolving unvulcanized rubber in a solvent is used as the adhesive, the support body and the gas permeable membrane can be bonded to each other to be integrated, and thus a ventilation member can be obtained.

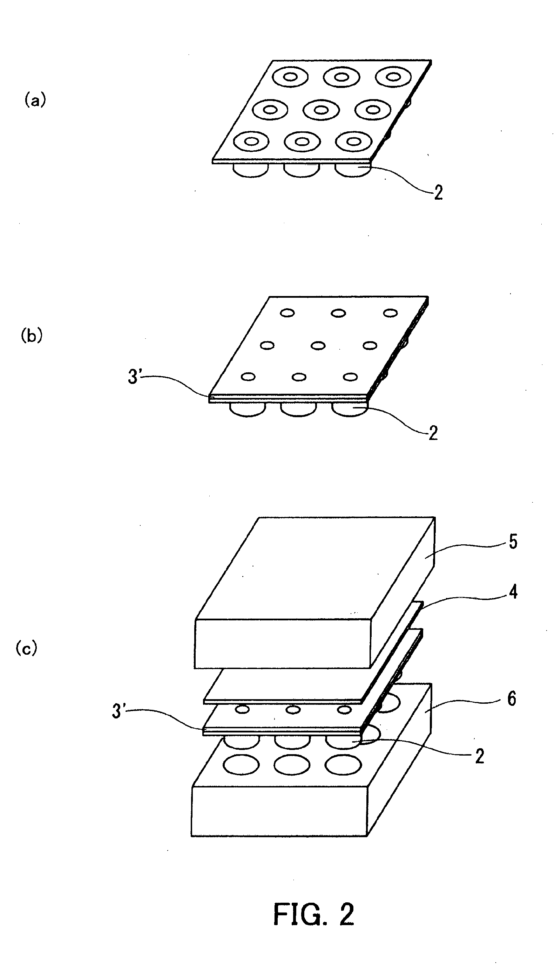

Accordingly, the production method of the present invention is a method for producing a ventilation member, including a step of applying an adhesive around a through hole of a support body composed of vulcanized EPDM rubber (application step); and a step of bonding a gas permeable membrane to the support body via the adhesive (bonding step). Fig. 2 shows schematically an example of the production method of the present invention.

The support body can be produced by kneading unvulcanized EPDM rubber, and then vulcanizing the rubber and molding it into a desired shape. In Fig. 2 (a), the rubber is molded into a sheet having nine support bodies 2. Producing such a sheet including a plurality of the support bodies 2 increases productivity.

In the application step, in order to ensure satisfactory adhesion between the support body and the gas permeable membrane, the rubber cement obtained by dissolving unvulcanized rubber in a solvent is used preferably as the adhesive. The solvent is not particularly limited as long as the unvulcanized rubber can be dissolved therein. For example, ketones, such as acetone, can be used. As the unvulcanized rubber, both of unvulcanized natural rubber and synthetic rubber can be used. From the viewpoint of adhesive strength, chemical resistance, weatherability, and ozone resistance of the bonding portion, unvulcanized EPDM rubber is preferable. The application of the adhesive can be performed according to a known method. In Fig. 2 (b), an adhesive 3' is applied on the sheet including the support bodies 2.

In the bonding step, the gas permeable membrane is placed on the adhesive first. At this time, it is preferable to apply appropriately a tension to the gas permeable membrane in order to allow the gas permeable membrane to be in firm contact with the adhesive. Subsequently, the gas permeable membrane is bonded to the support body with the adhesive. At this time, it is preferable to bond them together at a temperature in the range of room temperature to 200°C while applying a pressure thereto appropriately. In Fig. 2 (c), the gas permeable membrane, 4 is pressure-bonded to the sheet including the support bodies 2, on which the adhesive 3' has been applied, while applying a pressure thereto with a pressure-bonding jig 5 and a holding jig 6.

Through the pressure-bonding, the sheet including nine ventilation members can be obtained in Fig. 2. In this case, a step of cutting out these ventilation members is performed appropriately.

As described above, it is possible to obtain the ventilation member having high chemical resistance, weatherability, and ozone resistance as well as excellent heat resistance and mechanical strength. The ventilation member can be used for housings that accommodate electrical components such as an automobile lamp, motor, sensor, switch, and ECU.

### EXAMPLES

Hereinafter, the present invention will be described in detail with reference to Example and Comparative Example, but the present invention is not limited to the Example.

### EXAMPLE

A pasty mixture obtained by adding 20 parts by weight of a liquid lubricant (liquid paraffin) to 100 parts by weight of PTFE fine powder was preformed and formed into a round rod shape by paste extrusion. The resultant formed product was roll-pressed, and then the liquid lubricant was removed by extraction using normal decane to obtain a 0.2 mm-thick roll-pressed sheet. The obtained sheet was stretched at a stretching ratio of 5 in a longitudinal direction thereof at 280°C, and subsequently was stretched at a stretching ratio of 20 in a width direction thereof at 100°C using a tenter to obtain a porous PTFE membrane as the gas permeable membrane. The porous PTFE membrane had a thickness of 20 µm, a gas permeation quantity of 5 seconds/100 cc (measured with a Gurley measuring apparatus according to JIS P 8117 method), and a water pressure resistance of 150 kPa.

As the support body, there was prepared a support body having a φ6 mm through hole, obtained by vulcanizing and molding EPDM rubber (Esprene 501A produced by Sumitomo Chemical Co. Ltd.). As the adhesive, a rubber cement (a chemical cement produced by Nippon Tech Inc., containing unvulcanized EPDM rubber) was prepared.

The adhesive was applied around the through hole of the support body, and the porous PTFE membrane was placed on the portion applied with the adhesive while tension is applied thereto. They were maintained under pressure for 20 minutes to be pressure-bonded to each other by using jigs. Thus, a ventilation member was produced. The obtained ventilation member had a gas permeation quantity that is hardly different from that of the porous PTFE membrane alone (the gas permeation quantity in the case of φ6 mm was 130 seconds/100 cc in the ventilation member and 120 seconds/100 cc in the porous PTFE membrane.)

### Comparative Example

The above-mentioned porous PTFE membrane was set in a metal mold and EPDM rubber was injected thereinto to obtain a ventilation member by integral molding. It was impossible to measure a gas permeation quantity of the obtained ventilation member because it was extremely poor (1000 seconds/100 cc or more).

### INDUSTRIAL APPLICABILITY

The ventilation member of the present invention can be used for housings that accommodate electrical components such as an automobile lamp, motor, sensor, switch, and ECU.

## Claims

1. A ventilation member (1) **characterized by** comprising:
a support body (2) with a through hole, composed of vulcanized ethylene-propylene-diene rubber;
an adhesive layer (3) provided around the through hole; and
a gas permeable membrane (4) provided on the support body (2) via the adhesive layer (3) so as to cover the through hole,
wherein the adhesive layer (3) contains rubber and the gas permeable membrane (4) is a porous fluoresin membrane.

2. The ventilation member (1) according to claim 1, wherein the rubber is ethylene-propylene-diene rubber.

3. The ventilation member (1) according to claim 1, wherein the gas permeable membrane (4) has been subject to an oil repellent treatment.

4. A method for producing a ventilation member (1), **characterized by** comprising:
a step of applying an adhesive (3') around a through hole of a support body (2) composed of vulcanized ethylene-propylene-diene rubber; and
a step of bonding a gas permeable membrane (4) to the support body (2) via the adhesive (3'),
wherein the adhesive (3') is a rubber cement and the gas permeable membrane (4) is a porous fluoresin membrane.

5. The method for producing a ventilation member (1) according to claim 4, wherein the rubber cement contains unvulcanized ethylene-propylene-diene rubber.

## Patentansprüche

1. Belüftungselement (1), **dadurch gekennzeichnet, dass** es umfasst:
einen Trägerkörper (2) mit einer Durchgangsbohrung, der aus vulkanisiertem Ethylen-Propylen-Dien-Kautschuk besteht,
eine Adhäsivschicht (3), die um die Durchgangsbohrung herum vorgesehen ist, und
eine gasdurchlässige Membran (4), die auf dem Trägerkörper (2) mittels der Adhäsivschicht (3) vorgesehen ist, um die Durchgangsbohrung zu bedecken,
wobei die Adhäsivschicht (3) Kautschuk enthält und die gasdurchlässige Membran (4) eine poröse Fluorharzmembran ist.

2. Belüftungselement (1) nach Anspruch 1, wobei der Kautschuk Ethylen-Propylen-Dien-Kautschuk ist.

3. Belüftungselement (1) nach Anspruch 1, wobei die gasdurchlässige Membran (4) einer Ölabweisungsbehandlung unterzogen worden ist.

4. Verfahren zum Herstellen eines Belüftungselementes (1), **dadurch gekennzeichnet, dass** es umfasst:
einen Schritt des Auftragens eines Adhäsivs (3') um eine Durchgangsbohrung eines Trägerkörpers (2) herum, der aus einem vulkanisierten Ethyen-Propylen-Dien-Kautschuk besteht, und
einen Schritt des Bondens einer gasdurchlässigen Membran (4) an den Trägerkörper (2) mittels des Adhäsivs (3'),
wobei das Adhäsiv (3') ein Gummikit ist und die gasdurchlässige Membran (4) eine poröse Fluorharzmembran ist.

5. Verfahren zum Herstellen eines Belüftungselementes (1) nach Anspruch 4, wobei der Gummikit unvulkanisierten Ethylen-Propylen-Dien-Kautschuk enthält.

## Revendications

1. Elément de ventilation (1) **caractérisé en ce qu'**il comprend :
un corps de support (2) avec un trou traversant, composé de caoutchouc éthylène-propylène-diène vulcanisé ;
une couche adhésive (3) disposée autour du trou traversant ; et
une membrane perméable aux gaz (4) disposée sur le corps de support (2) via la couche adhésive (3) de manière à couvrir le trou traversant,
dans lequel la couche adhésive (3) contient du caoutchouc et la membrane perméable aux gaz (4) est une membrane de résine fluorée poreuse.

2. Elément de ventilation (1) selon la revendication 1, dans lequel le caoutchouc est du caoutchouc éthylène-propylène-diène.

3. Elément de ventilation (1) selon la revendication 1, dans lequel la membrane perméable aux gaz (4) a été soumise à un traitement oléofuge.

4. Procédé pour produire un élément de ventilation (1) **caractérisé en ce qu'**il comprend :
une étape d'application d'un adhésif (3') autour d'un trou traversant d'un corps de support (2) composé de caoutchouc éthylène-propylène-diène vulcanisé ; et
une étape de liaison d'une membrane perméable aux gaz (4) au corps de support (2) via l'adhésif (3'),
dans lequel l'adhésif (3') est une colle de caoutchouc et la membrane perméable aux gaz (4) est une membrane de résine fluorée poreuse.

5. Procédé pour produire un élément de ventilation (1) selon la revendication 4, dans lequel la dissolution de caoutchouc contient du caoutchouc éthylène-propylène-diène non vulcanisé.
